# EUROPEAN PATENT APPLICATION

(11) **EP 3 792 321 A1**
(43) Date of publication of application: **17.03.2021**
(21) Application number: 20175744.0
(22) Date of filing: 20.05.2020
(51) Int. Cl.: C09G 1/02, C09K 3/14, H01L 21/02, C08K 9/08, B24B 37/04

(54) **CARBON ABRASIVE AND POLISHING SLURRY AND METHOD OF MANUFACTURING SEMICONDUCTOR DEVICE**

(30) Priority: 11.09.2019 KR 20190113140
(71) Applicant: Samsung Electronics Co., Ltd., Gyeonggi-do 16677 (KR)
(72) Inventor: TAKAI, Kenji, Gyeonggi-do (KR); KIM, Do Yoon, Gyeonggi-do (KR)
(74) Representative: Elkington and Fife LLP

(57) **Abstract**

A carbon abrasive including a carbon nanoparticle and a positively charged polymer, a positively charged oligomer, of a combination thereof, on a surface of the carbon nanoparticle. A polishing slurry including the carbon abrasive, and a method of manufacturing a semiconductor device using the polishing slurry.

## Description

### FIELD OF THE INVENTION

A carbon abrasive, a polishing slurry, and a method of manufacturing a semiconductor device.

### BACKGROUND OF THE INVENTION

As electronic devices are reduced in size and integrated circuits are miniaturized, methods of forming fine structures such as metal wires of several nanometers or shallow trench isolation features is needed and is of interest. During the formation of a fine structure a polishing process may be performed to create a flat surface with a fine structure. One of the polishing processes is chemical mechanical polishing (CMP). Chemical mechanical polishing is a process including providing a polishing slurry between a substrate to be polished and a polishing pad and contacting the surface of the semiconductor substrate with the polishing pad, and using the polishing pad to planarize the surface of the semiconductor substrate by applying pressure and rotating the polishing pad and/or the semiconductor substrate.

### SUMMARY OF THE INVENTION

An embodiment provides an abrasive capable of improving a polishing rate while reducing damage and shape deformation of a structure.

Another embodiment provides polishing slurry including the abrasive.

Another embodiment provides a method of manufacturing a semiconductor device using the polishing slurry.

According to an embodiment, a carbon abrasive includes a carbon nanoparticle, and a positively charged polymer, a positively charged oligomer, or a combination thereof, disposed on a surface of the carbon nanoparticle.

The carbon nanoparticle may include at least one of a fullerene, a fullerene derivative, graphene, graphite, a carbon nanotube, or a carbon dot.

An average diameter of the carbon nanoparticle may be less than about 3 nanometer (nm).

The average diameter of the carbon abrasive may be about 2 to about 10 times larger than an average diameter of the carbon nanoparticle.

An average diameter of the carbon abrasive may be about 2 nm to about 10 nm.

The positively charged polymer may be selected from a polymer that may be dissoluble or dispersible in water.

The positively charged polymer may include a nitrogen-containing functional group.

The nitrogen-containing functional group may include at least one of an amino group, an amine group, ammonium group, or a nitrogen-containing heterocyclic group.

The positively charged polymer may include polyvinylpyrrolidone or a derivative of polyvinylpyrrolidone.

A weight average molecular weight of the polyvinylpyrrolidone or the derivative of polyvinylpyrrolidone may be about 3,000 grams per mole (g/mol) to about 150,000 g/mol.

The positively charged polymer may be adsorbed to a surface of the carbon nanoparticle, or the positively charged polymer may be bonded to a surface of the carbon nanoparticle.

The carbon nanoparticles may be passivated by the positively charged polymer or oligomer.

A weight ratio of the carbon nanoparticle and the positively charged polymer may be in a range of about 1:5 to about 1:1000.

The carbon abrasive may exhibit a positive charge in water.

According to another embodiment, a polishing slurry including the carbon abrasive is provided.

The polishing slurry may further include an oxidizing agent, a chelating agent, a surfactant, a dispersing agent, a pH controlling agent, a solvent, or a combination thereof.

According to another embodiment, a method of manufacturing a semiconductor device includes forming a first layer including a first material on a substrate, forming a plurality of trenches in the first layer, forming a second layer including a second material on the first layer and inside the trenches, the second material being different from the first material, and chemical mechanical polishing a surface of the second layer using the polishing slurry.

The second material may be a metal or an insulator.

The first material may be a silicon nitride and the second material may be a silicon oxide.

A polishing selectivity of the second layer relative to the first layer of the polishing slurry may be greater than or equal to about 500.

The carbon abrasive may replace a conventional oxide abrasive such as silica and thus the polishing selectivity may be improved while reducing damages and shape deformations of a fine structure.

### BRIEF DESCRIPTION OF THE DRAWINGS

FIGS. 1 to 4 are cross-sectional views showing a method of manufacturing a semiconductor device according to an embodiment.
FIG. 1 represents a first layer on a substrate;
FIG. 2 represents a first layer on a substrate with trenches formed in the first layer of FIG. 1;
FIG. 3 represents a second layer formed inside the trenches and on top of the first layer of FIG. 2;
FIG. 4 represents a planarization of the second layer of FIG. 3.

### DETAILED DESCRIPTION OF THE EMBODIMENTS

Example embodiments will hereinafter be described in detail, and may be easily performed by a person having an ordinary skill in the related art. However, this disclosure may be embodied in many different forms and is not to be construed as limited to the example embodiments set forth herein. Rather, these embodiments are provided so that this disclosure will be thorough and complete, and will fully convey the scope of the invention to those skilled in the art.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

As used herein, "polymer" refers to polymer, oligomer, or a combination thereof.

Hereinafter, an abrasive and a polishing slurry comprising the abrasive according to an embodiment is described.

According to an embodiment, the abrasive may be a carbon abrasive, and the carbon abrasive may include carbon nanoparticle and a polymer disposed on a surface of the carbon nanoparticle.

The carbon nanoparticle may be nanoparticle made of carbon or including carbon, for example a two-dimensional or three-dimensional nanoparticle consisting of carbon or comprising carbon as a main elemental component.

The carbon nanoparticle may be a particle having an average particle diameter of less than about 10 nanometers (nm), less than about 8 nm, less than about 7 nm, less than about 5 nm, for example less than about 3 nm, less than about 2 nm, or less than about 1 nm. The carbon nanoparticle may be a particle having an average particle diameter within a range of greater than or equal to about 0.01 nm and less than about 10 nm, greater than or equal to about 0.01 nm and less than about 8 nm, greater than or equal to about 0.01 nm and less than about 7 nm, greater than or equal to about 0.01 nm and less than about 5 nm, greater than or equal to about 0.01 nm and less than about 3 nm, greater than or equal to about 0.01 nm and less than about 2 nm, or greater than or equal to about 0.01 nm and less than about 1 nm.

The carbon nanoparticle may include, for example, fullerene, a fullerene derivative, graphene, graphite, a carbon nanotube, a carbon dot, or a combination thereof. For example, the carbon nanoparticle may be fullerene or a fullerene derivative. The fullerene may be, for example, C60, C70, C74, C76, or C78, but is not limited thereto. A fullerene derivative is a fullerene that has been surface-functionalized, for example, with a hydrophilic group, for example, amino group, polyamino group, carboxylic acid group, hydroxyl group, polyhydroxyl group, a sulfhydryl group, a carboxylic group, a carbonyl group, e.g., an amide group, a phosphate group, a hydrophilic or amphiphilic polymer that contains the aforementioned groups.

For example, the fullerene derivative may be a hydrophilic fullerene, and the hydrophilic fullerene may have a structure in which at least one hydrophilic functional group is bonded to the fullerene core. The fullerene core may be for example C60, C70, C74, C76, or C78, but is not limited thereto. The hydrophilic functional group may be for example at least one of a hydroxyl group, an amino group, a carbonyl group, a carboxyl group, a sulfhydryl group, and a phosphate group, but is not limited thereto. The hydrophilic functional group may be for example a hydroxyl group.

The hydrophilic fullerene may include at least 2 hydrophilic functional groups in average, for example 2 to 44 hydrophilic functional groups in average, 8 to 44 hydrophilic functional groups in average, 12 to 44 hydrophilic functional groups in average, 24 to 44 hydrophilic functional groups in average, 24 to 40 hydrophilic functional groups in average, 24 to 38 hydrophilic functional groups in average, 32 to 44 hydrophilic functional groups in average, 32 to 40 hydrophilic functional groups in average, or 32 to 38 hydrophilic functional groups in average per the fullerene core.

For example, the hydrophilic fullerene may be hydroxyl fullerene, and the hydroxyl fullerene may be represented by Cₓ(OH)_{y} (wherein, x may be 60, 70, 74, 76, or 78, and y may be 2 to 44). Herein, the average number of the hydroxyl groups of the hydroxyl fullerene may be determined by a method such as elemental analysis, thermogravimetric analysis, spectroscopic analysis, mass spectrometry, and the like, and may be for example an average value of the highest two peaks in a liquid chromatography mass spectrum (LCMS).

For example, the hydrophilic fullerene may be hydroxyl fullerene represented by Cₓ(OH)_{y} (wherein, x may be 60, 70, 74, 76, or 78, and y may be 12 to 44).

For example, the hydrophilic fullerene may be hydroxyl fullerene represented by Cₓ(OH)_{y} (wherein, x may be 60, 70, 74, 76, or 78, and y may be 24 to 44).

For example, the hydrophilic fullerene may be hydroxyl fullerene represented by Cₓ(OH)_{y} (wherein, x may be 60, 70, 74, 76, or 78, and y may be 32 to 44).

The polymer is disposed on a surface of the carbon nanoparticle and may be bonded to or adsorbed to the surface of the carbon nanoparticle. The bonded polymer may be covalently bonded or ionically bonded to a surface of the carbon nanoparticle. For example, the polymer may surround at least a portion of the surface of the carbon nanoparticle, and the carbon nanoparticle may be passivated by the polymer.

The polymer may be selected from polymers that may be stably bonded to or adsorbed to a surface of the carbon nanoparticle. The polymer may be selected from polymers that may be dissolved or dispersed in water. Accordingly, the abrasive may be effectively dissolved or dispersed in water and included in a polishing slurry.

For example, the polymer may be a charged polymer. The charged polymer may be a polymer with charges localized on at least a portion of the structural units of the polymer. For example, the polymer may be a positively charged polymer. The positively charged polymer may be a polymer that has one or more positive charges localized on at least a portion of the structural units. The positively charged polymer may surround at least a portion of the carbon nanoparticles, and for example carbon nanoparticles may be passivated by the positively charged polymer.

The positively charged polymer may include for example a nitrogen-containing functional group, and for example at least one of an amino group, an amine group, ammonium group, a nitrogen-containing heterocyclic group, or a combination thereof.

The positively charged polymer may include a structural unit with a side chain having a nitrogen-containing functional group. The positively charged polymer may include a hydrocarbon main chain such as polyolefin, and for example, a structural unit with a side chain having at least one of an amino group, an amine group, ammonium group, a nitrogen-containing heterocyclic group, or a combination thereof, on the hydrocarbon main chain.

The positively charged polymer may have at least one structural unit derived from vinylpyrrolidone, for example may be polyvinylpyrrolidone (PVP) or a derivative of polyvinylpyrrolidone. The polyvinylpyrrolidone or the derivative of PVP may have a weight average molecular weight of for example about 3,000 grams per mole (g/mol) to about 150,000 g/mol, and within the range, about 6,000 g/mol to about 150,000 g/mol or about 10,000 g/mol to about 150,000 g/mol. The term "derivative of polyvinylpyrrolidone" means a polymer with a structural unit derived from (1) a ring-substituted vinylpyrrolidone, and/or (2) a copolymer or co-oligomer with a structural unit derived from vinylpyrrolidone or a ring-substituted vinylpyrrolidone.

The polymer may be bonded to or adsorbed to a surface of a carbon nanoparticle in a variety of ways.

The polymer adsorbed to a surface, for example, may be directly coated or passivated on a surface of the carbon nanoparticle. For example, a carbon nanoparticle dispersion in which carbon nanoparticles are dispersed and a polymer solution in which the polymer is dissolved or dispersed are prepared respectively, and after blending the carbon nanoparticle dispersion and the polymer solution the blended solution is mixed with water to obtain carbon nanoparticles coated or passivated with the polymer.

The carbon nanoparticle dispersion may be obtained by dispersing carbon nanoparticles in an aromatic hydrocarbon solvent. The aromatic hydrocarbon solvent may be for example toluene, xylene, benzene, chloro benzene, naphthalene, or a mixture thereof, for example 1-chloronaphthalene, 1-methylnaphthalene, 1,2-dichlorobenzene, 1,2,4-trimethylbenzene, tetrahydronaphthalene, carbon disulfide, 1,2,3-tribromopropane, chlorobenzene, p-xylene, bromoform, cumene, benzene, or a mixture thereof. A concentration of carbon nanoparticle dispersion may be about 0.1 wt% to about 10 wt%, and within the range, about 0.3 wt% to about 7 wt% or about 0.5 wt% to about 3 wt%.

The polymer solution may be, for example, obtained by dissolving or dispersing the polymer in a hydrophilic solvent, and the hydrophilic solvent may be for example an alcohol such as ethanol. A blending ratio of the carbon nanoparticle dispersion and the polymer solution may be about 1:1 to about 1:10 (w/w), and within the range, may be about 1:1 to about 1:5 or about 1:1 to about 1:3 (w/w). A concentration of the carbon nanoparticles coated or passivated with a polymer which are dispersed in water may be about 1 wt% to about 30 wt%, and within the range may be about 3 wt% to about 25 wt% or about 5 wt% to about 20 wt%.

For example, the polymer may be bonded to a surface by polymerization at the surface of a carbon nanoparticle. The polymerization may be for example graft polymerization. For example, the carbon nanoparticle dispersion in which the carbon nanoparticles are dispersed is prepared, monomers and a polymerization initiator are added to the carbon nanoparticle dispersion and the monomers are reacted to obtain carbon nanoparticles coated or passivated with the polymer or oligomer.

The carbon nanoparticle dispersion may be prepared as described above.

The monomer may be one or more monomers, for example one or more monomers that is obtained from a cationic polymer or oligomer, one or more monomers having a positive charge, one or more monomers including a nitrogen-containing functional group, or one or more monomers including at least one of an amino group, an amine group, an ammonium group, and a nitrogen-containing heterocyclic group. For example, the monomer may include a vinylpyrrolidone, and for example N-vinylpyrrolidone. The monomer may be added in an amount of about 30 molar equivalents to about 1000 molar equivalents based on the carbon nanoparticles, and within the range, may be added in an amount of about 50 molar equivalents to about 800 molar equivalents or about 100 molar equivalents to about 500 molar equivalents.

The polymerization initiator may be for example a thermal polymerization initiator or a photopolymerization initiator, and for example a thermal polymerization initiator. The polymerization initiator may be for example azo compounds such as azobisisobutyronitrile (AIBN), 2,2'-azobis-(2,4-dimethylvaleronitrile), or 2,2-azobis-(4-methoxy-2,4-dimethylvaleronitrile); organic peroxide such as benzoyl peroxide, lauryl peroxide, t-butylperoxy-pivalate, t-butylperoxy-ethylhexanolate, 1,1'-bis-(t-butylperoxy) cyclohexane, t-amylperoxy-2-ethylhexanolate, or t-hexylperoxy-2-ethylhexanolate; and hydrogen peroxide, but is not limited thereto. The polymerization initiator may be added in a range of amounts that may fully function as the polymerization initiator and may not cause precipitation of crystals, and for example may be added at about 0.01 to about 20 parts by weight based on 100 parts by weight of carbon nanoparticles.

The reaction may be performed for about 1 hour to about 40 hours at about 30 °C to about 90 °C, and within the range, may be performed for about 5 hours to about 20 hours at about 50 °C to about 70 °C. According to the reaction, carbon nanoparticles coated or passivated with the polymer may be obtained.

A weight ratio of the carbon nanoparticles to the polymer included in the carbon abrasive may be in a range of about 1:2 to about 1:1000, and within the range, about 1:5 to about 1:1000, about 1:5 to about 1:500, about 1:10 to about 1:300, or about 1:10 to about 1:100.

The carbon abrasive may be larger than the carbon nanoparticles by including the polymer coated or passivated on the surface of the carbon nanoparticles, as described above. Accordingly, the average particle diameter of the carbon abrasive may be larger than the average particle diameter of the carbon nanoparticles. For example, the average particle diameter of the carbon abrasive may be about twice or more, about 3 times or more, about 5 times or more, about twice to about 20 times, about twice to about 15 times, about twice to about 10 times, about 3 times to about 20 times, about 3 times to about 15 times, about 3 times to about 10 times, about 5 times to about 20 times, about 5 times to about 15 times or about 5 times to about 10 times as large as the average particle diameter of carbon nanoparticles.

The average particle diameter of the carbon abrasive may be about 2 nm to 20 nm, and within the range, about 3 nm to about 20 nm, about 4 nm to about 20 nm, about 2 nm to about 10 nm, about 3 nm to about 10 nm, about 4 nm to about 10 nm, or about 4 nm to about 8 nm. Herein, the average particle diameter of the carbon abrasive is a median of volume distribution measured by a laser diffraction particle size analyzer, and for example a laser diffraction particle size analyzer, Zetasizer (Malvern).

Since the carbon abrasive includes a positively charged polymer as described above, the carbon abrasive may be a positively charged carbon abrasive having a positive charge on the surface. For example, the carbon abrasive may be a positively charged carbon abrasive that is positively charged in water.

The aforementioned carbon abrasive may be included in the polishing slurry. The polishing slurry may be for example a slurry used for polishing a conductor, an insulator and/or a semiconductor in a chemical mechanical polishing.

Hereinafter, a polishing slurry according to an embodiment is described.

According to an embodiment, the polishing slurry includes an abrasive and a solvent.

The abrasive includes the aforementioned carbon abrasive. The descriptions of the carbon abrasive are as described above. The carbon abrasive may be included in an amount of about 0.01 wt% to about 20 wt% based on the polishing slurry. Within the range, the carbon abrasive may be included in an amount of about 0.01 wt% to about 15 wt%, about 0.01 wt% to about 10 wt%, about 0.01 wt% to about 8 wt%, about 0.01 wt% to about 7 wt%, about 0.01 wt% to about 5 wt%, about 0.01 wt% to about 3 wt%, about 0.01 wt% to about 2 wt%, about 0.0 1wt% to about 1 wt%, about 0.01 wt% to about 0.8 wt%, or about 0.01 wt% to about 0.5 wt%.

The abrasive may further include other abrasives or polishing particles in addition to the carbon abrasive described above.

The solvent may be a polar solvent for example, water, alcohol, acetic acid, acetone, or a mixture thereof. For example, the solvent may be water, for example distilled water, deionized water, ion exchange water, and/or ultrapure water.

The polishing slurry may further include an additive and the additive may be for example an oxidizing agent, a chelating agent, a surfactant, a dispersing agent, a pH controlling agent, or a combination thereof, but is not limited thereto.

The oxidizing agent may be for example hydrogen peroxide, aqueous hydrogen peroxide, sodium hydroxide, potassium hydroxide, or a combination thereof, but is not limited thereto.

The chelating agent may be for example phosphoric acid, nitric acid, citric acid, malonic acid, a salt thereof, or a combination thereof, but is not limited thereto.

The surfactant may be an ionic or non-ionic surfactant, for example a copolymer of ethylene oxide, a copolymer of propylene oxide, an amine compound, or a combination thereof, but is not limited thereto.

The dispersing agent may promote dispersibility of the abrasive and may include for example a water-soluble monomer, a water-soluble oligomer, a water-soluble polymer, a metal salt, or a combination thereof. The weight average molecular weight of the water-soluble polymer may be for example less than or equal to about 10,000 g/mol, for example, less than or equal to about 5000 g/mol, or less than or equal to about 3000 g/mol. The metal salt may be for example a copper salt, a nickel salt, a cobalt salt, a manganese salt, a tantalum salt, a ruthenium salt, or a combination thereof. The dispersing agent may be for example selected from poly(meth)acrylic acid, poly(meth)acryl maleic acid, polyacrylonitrile-co-butadiene-acrylic acid, polyoxyethylene diglyceryl ether, carboxylic acid, sulfonic ester, sulfonic acid, phosphoric ester, cellulose, diol, a salt thereof, or a combination thereof, but is not limited thereto.

The pH controlling agent may control pH of the polishing slurry and may be for example, inorganic acid, inorganic base, organic acid, organic base, a salt thereof, or a combination thereof. The inorganic acid may include for example nitric acid, hydrochloric acid, phosphoric acid, sulfuric acid, hydrofluoric acid, hydrobromic acid, iodic acid, or a salt thereof. The inorganic base may include sodium hydroxide, potassium hydroxide, ammonia, or a salt thereof. The organic acid may include for example formic acid, malonic acid, maleic acid, oxalic acid, adipic acid, citric acid, acetic acid, propionic acid, butyric acid, fumaric acid, lactic acid, salicylic acid, benzoic acid, succinic acid, phthalic acid, glutaric acid, glutamic acid, glycolic acid, aspartic acid, tartaric acid, carboxylic acid, acrylic acid or a salt thereof. The organic base may include ethanolamine, but are not limited thereto.

Each additive may be independently for example included in a trace amount of about 1 parts per million (ppm) to about 100,000 ppm based on the polishing slurry, but is not limited thereto.

The polishing slurry may be employed for providing the various structures, for example, the polishing slurry may be applied for a polishing process of a conductor such as a metal wire, or a polishing process of an insulator such as an insulation layer or a shallow trench isolation (STI).

For example, the polishing slurry may be used to polish a conductive layer, an insulation layer, and/or a semiconductor layer having a charged surface in a semiconductor substrate, and may be for example effectively used to polish a conductive layer, an insulation layer, and/or a semiconductor layer having a negatively charged surface.

For example, the polishing slurry may be used to polish conductors such as a metal wire in a semiconductor substrate, and may be used for example to polish a conductor such as copper (Cu), tungsten (W), or an alloy thereof.

For example, the polishing slurry may be used to polish a shallow trench isolation (STI) or an insulation layer in a semiconductor substrate, and may be for example used to polish a silicon oxide or a silicon nitride.

For example, the polishing slurry may exhibit high polishing selectivity for different materials, and for example, the polishing selectivity of a polished object (material A) relative to a reference object (material B) may be about 100 or more than for a reference object (material B), about 300 or more, about 500 or more, about 600 or more, about 700 or more, about 800 or more, about 900 or more, or about 1000 or more. The polishing slurry may exhibit high polishing selectivity for different materials A and B, and within a range, about 100 to about 5000, about 300 to about 5000, about 500 to about 5000, about 600 to about 5000, about 700 to about 5000, about 800 to about 5000, about 900 to about 5000, or about 1000 to about 5000. The polishing selectivity may be a ratio of polishing rate (material removal rate, MRR in Angstroms per minute (Å/min)).

For example, a polishing rate of the polished object (material A) may be about 500 Å/min or more, within the range, about 700 Å/min or more, about 800 Å/min or more, about 900 Å/min or more, about 1000 Å/min or more, about 500 to about 5000 Å/min, about 700 to about 5000 Å/min, about 800 to about 5000 Å/min, about 900 to about 5000 Å/min, or about 1000 to about 5000 Å/min.

For example, the polishing slurry may satisfy the polishing rate of polished object (material A) of about 500 Å/min or more and polishing selectivity of about 100 or more simultaneously, and within the range, the polishing rate of polished object (material A) of about 700 Å/min or more and polishing selectivity of about 300 or more simultaneously, the polishing rate of polished object (material A) of about 900 Å/min or more and polishing selectivity of about 500 or more simultaneously, or the polishing rate of polished object (material A) of about 1000 Å/min or more and polishing selectivity of about 800 or more simultaneously.

For example, material A may be silicon oxide, and material B may be silicon nitride.

Hereinafter, an example of a method of manufacturing a semiconductor device using the polishing slurry is described. As an example, a shallow trench isolation (STI) process is described.

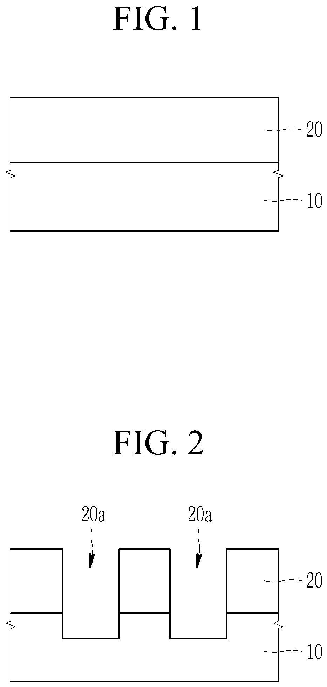

FIGS. 1 to 4 are cross-sectional views showing a method of manufacturing a semiconductor device according to an embodiment.

Referring to FIG. 1, a first layer 20 is formed on the semiconductor substrate 10. The first layer 20 may include a first material and the first material may include for example an oxide, a nitride, and/or an oxynitride. For example, the first material may include a nitride, for example a silicon nitride. The first layer 20 may be for example a pad nitride layer.

Referring to FIG. 2, the first layer 20 and a part of the semiconductor substrate 10 are etched to form trenches 20a at positions corresponding to the device isolation regions. The trenches 20a may be formed by a photolithography process using an isolation mask (not shown), but is not limited thereto.

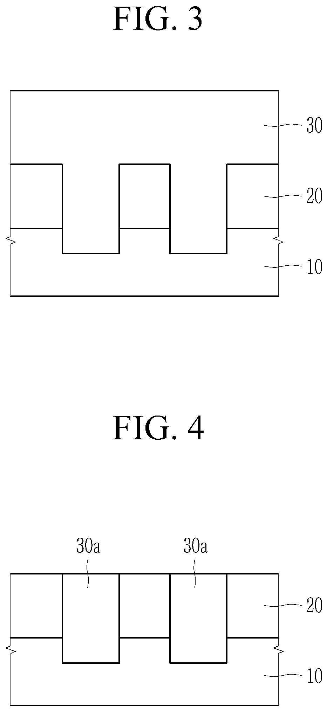

Referring to FIG. 3, the second layer 30 is formed inside the trench 20a and on the first layer 20. The second layer 30 may include a second material different from the first material, and the second material may include for example an oxide, a nitride, and/or an oxynitride. For example, the first material may include a nitride and the second material may include an oxide. For example, the first material may include a silicon nitride and the second material may include a silicon oxide. For example, the second material may include silicate, for example tetraethyl orthosilicate, phosphosilicate glass (PSG), borophosphosilicate glass (BPSG), or a combination thereof, but is not limited thereto.

Referring to FIG. 4, a surface of the second layer 30 is planarized to match the surface of the first layer 20 and thus form a filled second layer 30a. The planarization may be performed by chemical mechanical polishing using a chemical mechanical polishing (CMP) equipment, and may use the above-described polishing slurry, which will be described later.

The chemical mechanical polishing equipment may include for example a lower base; a platen rotatable on the lower base; a polishing pad disposed on the platen; a pad conditioner; and at least one polishing slurry supplying equipment disposed adjacent to the polishing pad and supplying the polishing pad with the polishing slurry.

The platen may be rotated on the surface of the lower base. For example, the platen may be supplied with a rotation power from a motor disposed in the lower base. Accordingly, the platen may be rotated with a center of an imaginary rotating axis perpendicular to the surface thereof. The imaginary rotating axis may be perpendicular to the surface of the lower base.

The platen may be equipped with at least one supply line through which liquid is injected and discharged. Water may be injected and discharged through the supply line inside the platen and thus adjust a temperature of the platen. For example, cooling water may be injected and discharged through the supply line inside the platen and thus cool down the temperature of the platen. For example, hot water at a high temperature may be injected and discharged through the supply line inside the platen and thus increase the temperature of the platen.

The polishing pad may be disposed on the surface of the platen so that it may be supported by the platen. The polishing pad may be rotated together with the platen. The polishing pad may have a rough polishing surface. Such a polishing surface may directly contact a polished object and thus mechanically polish the surface of the polished object. The polishing pad may be a porous material having a plurality of micropores which may hold the polishing slurry.

The pad conditioner may be disposed adjacent to the polishing pad and maintain a polishing surface so that the surface of the polished object may be effectively polished.

The polishing slurry supplying equipment may be disposed adjacent to the polishing pad and thus supply the polishing pad with the polishing slurry. The polishing slurry supplying equipment may include a nozzle supplying the polishing slurry on the polishing pad and a voltage supplying unit applying a predetermined voltage to the nozzle. The polishing slurry in the nozzle is charged by a voltage applied by the voltage supplying unit and thus discharged toward the polishing pad. The polishing slurry supplying equipment may supply the aforementioned polishing slurry.

The chemical mechanical polishing may be for example performed by placing the second layer 30 of the semiconductor substrate 10 to face a polishing pad, supplying the aforementioned polishing slurry from polishing slurry supplying equipment between the second layer 30 of the semiconductor substrate 10 and the polishing pad, and performing polishing by contacting the surface of the second layer 30 of the semiconductor substrate 10 with the polishing pad.

For example, when the first layer 20 includes a silicon nitride and the second layer 30 includes a silicon oxide, the higher the polishing selectivity of the second layer 30 relative to the first layer 20 of the polishing slurry is, greater. For example, the polishing selectivity may be about 100 or more, about 300 or more, about 500 or more, about 600 or more, about 700 or more, about 800 or more, about 900 or more, or about 1000 or more, or within the range, about 100 to about 5000, about 300 to about 5000, about 500 to about 5000, about 600 to about 5000, about 700 to about 5000, about 800 to about 5000, about 900 to about 5000, or about 1000 to about 5000. By having the polishing selectivity as described above, polishing of the second layer 30 may be effectively performed without damaging the first layer 20.

For example, the supplying of the polishing slurry may be for example at a rate of about 10 milliliters per minute (ml/min) to about 100 ml/min, for example at a flow rate of about 2 microliters (ul) to about 10 ul.

The polishing may be performed by contacting the surface of the second layer 30 of the semiconductor substrate 10 with the polishing pad and rotating them to produce a mechanical friction. For example, a pressure of about 1 pounds per inch square (psi) to about 5 psi may be applied during the polishing step.

Even though the shallow trench isolation process has been described as an example of the method of manufacturing a semiconductor device, the present disclosure is not limited thereto and may be applied to various processes.

Hereinafter, the embodiments are illustrated in more detail with reference to examples. However, these examples are exemplary, and the present disclosure is not limited thereto.

### Synthesis Examples

### Synthesis Example 1

200 milligrams (mg) of fullerene (C60, Frontier Carbon Corp.) is dispersed in 200 milliliters (ml) of toluene to prepare a fullerene dispersion. 20 grams (g) of polyvinylpyrrolidone (PVP, Mw 10,000 g/mol, Nippon Shokubai Co., Ltd.) is dispersed in 100 ml of ethanol to prepare a polymer dispersion. Subsequently, the fullerene dispersion and the polymer dispersion are mixed and then, stirred at room temperature for 24 hours to obtain a mixed dispersion.

The toluene and ethanol are evaporated (removed under vacuum) from the mixed dispersion to obtain a solid, and 300 ml of water is added to the solid to prepare a suspension. Subsequently, the water is evaporated (removed under vacuum) from the suspension, and the residue is dried and weighed. Water is added to the dried residue to have a particle (solid) concentration of 10 percent by weight (wt%) and the aqueous mixture is ultrasonicated to obtain a PVP-fullerene dispersion including PVP-fullerene particles.

### Synthesis Example 2

PVP-fullerene dispersion is obtained according to the same synthesis method as Synthesis Example 1 except that polyvinylpyrrolidone (Mw 40,000 g/mol, Nippon Shokubai Co., Ltd.) is used instead of the polyvinylpyrrolidone (Mw 10,000 g/mol).

### Synthesis Example 3

PVP-fullerene dispersion is obtained according to the same synthesis method as Synthesis Example 1 except that 600 mg of fullerene is used instead of 200 mg of fullerene.

### Synthesis Example 4

PVP-fullerene dispersion is obtained according to the same synthesis method as Synthesis Example 1 except that 600 mg of fullerene is used instead of 200 mg of fullerene, and polyvinylpyrrolidone (Mw 40,000 g/mol) is used instead of the polyvinylpyrrolidone (Mw 10,000 g/mol).

### Synthesis Example 5

1 g of fullerene (C60, Frontier Carbon Corp.) and 0.02 g of azobisisobutyronitrile (AIBN) are put in 200 g of 1,2-dichlorobenzene, and additionally, N-vinylpyrrolidone (NVP) is added thereto to be 100 molar equivalents based on the fullerene. Subsequently, the obtained mixture is graft-polymerized at 60 °C for 17 hours. The resulting solids are repetitively centrifuged, washed, and dried. Water is added to the washed solids to have a particle concentration of 10 wt%, and ultrasonication of the aqueous mixture is performed to obtain PVP-fullerene dispersion including PVP-fullerene particles.

### Synthesis Example 6

PVP-fullerene dispersion is obtained according to the same synthesis method as Synthesis Example 5 except that N-vinylpyrrolidone is used to be 500 molar equivalents based on the fullerene.

### Comparative Synthesis Example 1

3 g of Nanom spectra D100 including hydroxyl fullerene having 10 hydroxy groups on average (C₆₀(OH)₁₀) as a main component (Frontier Carbon Corp.), 300 ml of 30 wt% hydrogen peroxide in water (Fuji Film Wako Pure Chemical Corp.), and 120 ml of 28 wt% ammonia in water, are put in a 500 ml flask and reacted at 60 °C for 10 hours. Subsequently, 1 liter (L) of isopropyl alcohol, 1 L of diethyl ether, and 1 L of hexane are sequentially added to the reaction mixture to facilitate precipitate formation. The precipitate is separated from the liquid solvents, washed, and then, dried under reduced pressure to provide amino group-bound fullerene particles. Water is added to the amino group-bound fullerene particles to have a particle (solid) concentration of 10 wt% and the aqueous mixture is ultrasonicated to obtain a dispersion including the amino group-bound fullerene particle.

### Comparative Synthesis Example 2

A dispersion of 10 wt% colloidal silica (an average particle diameter: 40 nm) in water is prepared.

### Evaluation I

Average particle diameters of the PVP-fullerene particles according to Synthesis Examples are evaluated.

The average particle diameters are evaluated as a median value of a volume distribution obtained by using a laser diffraction type particle size analyzer (Zetasizer, Malvern Panalytical Ltd.).

The results are shown in Table 1.

**Table 1**

| | Average particle diameter (nm) |
|---|---|
| Synthesis Example 1 | 6.5 |
| Synthesis Example 2 | 6.3 |
| Synthesis Example 3 | 4.7 |
| Synthesis Example 4 | 4.5 |
| Synthesis Example 5 | 4.3 |
| Synthesis Example 6 | 6.7 |
| Comparative Synthesis Example 1 | 1.3 |
| Comparative Synthesis Example 2 | 40 |
| Ref. C60 | ≤ 1 |

### Preparation Examples

### Preparation Example 1

Additional water is added to the 10 wt% PVP-fullerene dispersion of Synthesis Example 1 to have a particle concentration of 0.4 wt% in water. Then, 0.1 wt% of tetrahydrofuran-2-carboxylic acid and 0.01 wt% of polyoxyethylene diglyceryl ether (Mw 750 g/mol) is added to the aqueous PVP-fullerene dispersion and mixed therewith, and ethanolamine is added thereto to obtain polishing slurry having a pH 3.5.

### Preparation Example 2

Polishing slurry is prepared according to the same method as Preparation Example 1 except that water is added to the PVP-fullerene dispersion of Synthesis Example 1 to have a particle concentration of 4 wt%.

### Preparation Example 3

Polishing slurry is prepared according to the same method as Preparation Example 1 except that the PVP-fullerene dispersion of Synthesis Example 2 (polyvinylpyrrolidone (Mw 40,000 g/mol) is used instead of the PVP-fullerene dispersion of Synthesis Example 1.

### Preparation Example 4

Polishing slurry is prepared according to the same method as Preparation Example 1 except that the PVP-fullerene dispersion of Synthesis Example 2 (polyvinylpyrrolidone (Mw 40,000 g/mol) is used, and water is added thereto to have a particle concentration of 4 wt%.

### Preparation Example 5

Polishing slurry is prepared according to the same method as Preparation Example 1 except that the PVP-fullerene dispersion of Synthesis Example 3 is used instead of the PVP-fullerene dispersion of Synthesis Example 1.

### Preparation Example 6

Polishing slurry is prepared according to the same method as Preparation Example 1 except that the PVP-fullerene dispersion of Synthesis Example 3 is used instead of the PVP-fullerene dispersion of Synthesis Example 1, and water is added thereto to have a particle concentration of 4 wt%.

### Preparation Example 7

Polishing slurry is prepared according to the same method as Preparation Example 1 except that the PVP-fullerene dispersion of Synthesis Example 4 (polyvinylpyrrolidone (Mw 40,000 g/mol) is used instead of the PVP-fullerene dispersion of Synthesis Example 1.

### Preparation Example 8

Polishing slurry is prepared according to the same method as Preparation Example 1 except that the PVP-fullerene dispersion of Synthesis Example 4 (polyvinylpyrrolidone (Mw 40,000 g/mol) is used instead of the PVP-fullerene dispersion of Synthesis Example 1, and water is added thereto to have a particle concentration of 4 wt%.

### Preparation Example 9

Polishing slurry is prepared according to the same method as Preparation Example 1 except that the PVP-fullerene dispersion of Synthesis Example 5 is used instead of the PVP-fullerene dispersion of Synthesis Example 1.

### Preparation Example 10

Polishing slurry is prepared according to the same method as Preparation Example 1 except that the PVP-fullerene dispersion of Synthesis Example 5 is used instead of the PVP-fullerene dispersion of Synthesis Example 1, and water is added thereto to have a particle concentration of 4 wt%.

### Preparation Example 11

Polishing slurry is prepared according to the same method as Preparation Example 1 except that the PVP-fullerene dispersion of Synthesis Example 6 is used instead of the PVP-fullerene dispersion of Synthesis Example 1.

### Preparation Example 12

Polishing slurry is prepared according to the same method as Preparation Example 1 except that the PVP-fullerene dispersion of Synthesis Example 6 is used instead of the PVP-fullerene dispersion of Synthesis Example 1, and water is added thereto to have a particle concentration of 4 wt%.

### Comparative Preparation Example 1

Polishing slurry is prepared according to the same method as Preparation Example 1 except that the dispersion including the amino group-bound fullerene particles according to Comparative Synthesis Example 1 is used instead of the 10wt% PVP-fullerene dispersion of Synthesis Example 1.

### Comparative Preparation Example 2

Polishing slurry is prepared according to the same method as Preparation Example 1 except that the dispersion including the amino group-bound fullerene particles according to Comparative Synthesis Example 1 is used instead of the PVP-fullerene dispersion of Synthesis Example 1, and water is added thereto to have a particle concentration of 4 wt%.

### Comparative Preparation Example 3

Polishing slurry is prepared according to the same method as Preparation Example 1 except that the colloidal silica dispersion according to Comparative Synthesis Example 2 is used instead of the PVP-fullerene dispersion of Synthesis Example 1.

### Comparative Preparation Example 4

Polishing slurry is prepared according to the same method as Preparation Example 1 except that the colloidal silica dispersion according to Comparative Synthesis Example 2 is used instead of the PVP-fullerene dispersion of Synthesis Example 1, and water is added thereto to have a particle concentration of 4 wt%.

### Examples

### Example 1

Chemical mechanical polishing is performed under the following conditions.
(1) CMP equipment: Mirra (Applied Materials)
(2) Polishing pad: 2-layer pad (VP-3100, Dow)
(3) Polished object 1: an 8-inch blanket wafer with a silicon oxide layer formed by CVD using tetraethoxysilane as a raw material
(4) Polished object 2: an 8-inch blanket wafer with silicon nitride formed by CVD
(5) Rotation rate of polishing platen: 96 rpm
(6) Rotation rate of polishing pad: 93 rpm
(7) applied pressure: 22 kPa (3.2 psi)
(8) Polishing slurry: polishing slurry according to Preparation Example 1
(9) Feed rate of polishing slurry: 200 ml/min

### Example 2

Chemical mechanical polishing is performed under the same conditions as Example 1 except that the polishing slurry of Preparation Example 2 is used instead of the polishing slurry of Preparation Example 1.

### Example 3

Chemical mechanical polishing is performed under the same conditions as Example 1 except that the polishing slurry of Preparation Example 3 is used instead of the polishing slurry of Preparation Example 1.

### Example 4

Chemical mechanical polishing is performed under the same conditions as Example 1 except that the polishing slurry of Preparation Example 4 is used instead of the polishing slurry of Preparation Example 1.

### Example 5

Chemical mechanical polishing is performed under the same conditions as Example 1 except that the polishing slurry of Preparation Example 5 is used instead of the polishing slurry of Preparation Example 1.

### Example 6

Chemical mechanical polishing is performed under the same conditions as Example 1 except that the polishing slurry of Preparation Example 6 is used instead of the polishing slurry of Preparation Example 1.

### Example 7

Chemical mechanical polishing is performed under the same conditions as Example 1 except that the polishing slurry of Preparation Example 7 is used instead of the polishing slurry of Preparation Example 1.

### Example 8

Chemical mechanical polishing is performed under the same conditions as Example 1 except that the polishing slurry of Preparation Example 8 is used instead of the polishing slurry of Preparation Example 1.

### Example 9

Chemical mechanical polishing is performed under the same conditions as Example 1 except that the polishing slurry of Preparation Example 9 is used instead of the polishing slurry of Preparation Example 1.

### Example 10

Chemical mechanical polishing is performed under the same conditions as Example 1 except that the polishing slurry of Preparation Example 10 is used instead of the polishing slurry of Preparation Example 1.

### Example 11

Chemical mechanical polishing is performed under the same conditions as Example 1 except that the polishing slurry of Preparation Example 11 is used instead of the polishing slurry of Preparation Example 1.

### Example 12

Chemical mechanical polishing is performed under the same conditions as Example 1 except that the polishing slurry of Preparation Example 12 is used instead of the polishing slurry of Preparation Example 1.

### Comparative Example 1

Chemical mechanical polishing is performed under the same conditions as Example 1 except that the polishing slurry of Comparative Preparation Example 1 is used instead of the polishing slurry of Preparation Example 1.

### Comparative Example 2

Chemical mechanical polishing is performed under the same conditions as Example 1 except that the polishing slurry of Comparative Preparation Example 2 is used instead of the polishing slurry of Preparation Example 1.

### Comparative Example 3

Chemical mechanical polishing is performed under the same conditions as Example 1 except that the polishing slurry of Comparative Preparation Example 3 is used instead of the polishing slurry of Preparation Example 1.

### Comparative Example 4

Chemical mechanical polishing is performed under the same conditions as Example 1 except that the polishing slurry of Comparative Preparation Example 4 is used instead of the polishing slurry of Preparation Example 1.

### Evaluation II

After performing chemical mechanical polishing according to Examples 1 to 12, and Comparative Examples 1 to 4, a polishing rate and scratch or not are evaluated.

The polishing rate (material removal rate, MRR in Angstroms per minute (Å/min)) is evaluated by performing polishing for 60 seconds and measuring thicknesses of a silicon oxide layer and a silicon nitride layer before and after the polishing by using a thickness-measuring device (F80, FILMETRICS Inc.).

Polishing selectivity is evaluated as a ratio of a polishing rate of a polished object 1 (the silicon oxide layer) relative to a polishing rate of a polished object 2 (the silicon nitride layer).

The polishing scratch is evaluated by counting the number of polishing scratches on the polished object 2 (the silicon nitride layer) with a scanning electron microscope.

The results are shown in Table 2.

**Table 2**

| | MRR (Å/min) | | Polishing selectivity | Number of Scratches |
|---|---|---|---|---|
| | Polished object 1 (silicon oxide) | Polished object 2 (silicon nitride) | | |
| Example 1 | 1150 | 1.1 | 1045.5 | 0 |
| Example 2 | 1320 | 1.3 | 1015.4 | 0 |
| Example 3 | 1180 | 1.1 | 1072.7 | 0 |
| Example 4 | 1280 | 1.2 | 1066.7 | 0 |
| Example 5 | 1230 | 1.2 | 1025.0 | 0 |
| Example 6 | 1380 | 1.5 | 920.0 | 0 |
| Example 7 | 1260 | 1.3 | 969.2 | 0 |
| Example 8 | 1350 | 1.4 | 964.3 | 0 |
| Example 9 | 1380 | 1.3 | 1061.5 | 0 |
| Example 10 | 1570 | 1.5 | 1046.7 | 0 |
| Example 11 | 1170 | 1.2 | 975.0 | 0 |
| Example 12 | 1290 | 1.4 | 921.4 | 0 |
| Comparative Example 1 | 230 | 0.7 | 328.6 | 0 |
| Comparative Example 2 | 220 | 0.5 | 440.0 | 0 |
| Comparative Example 3 | 1560 | 60 | 26.0 | 8 |
| Comparative Example 4 | 1930 | 90 | 21.4 | 13 |

Referring to Table 2, when the chemical mechanical polishing is performed by using the polishing slurry according to Preparation Examples, polishing rate and/or polishing selectivity are greatly increased compared with when the chemical mechanical polishing is performed by using the polishing slurry according to Comparative Preparation Examples.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

## Claims

1. A carbon abrasive comprising
a carbon nanoparticle, and
a positively charged polymer, a positively charged oligomer, or a combination thereof, disposed on a surface of the carbon nanoparticle.

2. The carbon abrasive of claim 1, wherein the carbon nanoparticle comprises at least one of a fullerene, a fullerene derivative, graphene, graphite, a carbon nanotube, or a carbon dot.

3. The carbon abrasive of claims 1 or 2, wherein an average particle diameter of the carbon nanoparticle is less than 3 nanometers;
preferably wherein an average particle diameter of the carbon abrasive is 2 to 10 times larger than the average particle diameter of the carbon nanoparticle.

4. The carbon abrasive of any of claims 1-3, wherein an average particle diameter of the carbon abrasive is 2 nanometers to 10 nanometers.

5. The carbon abrasive of any of claims 1-4, wherein the positively charged polymer is dissoluble or dispersible in water.

6. The carbon abrasive of any of claims 1-5, wherein the positively charged polymer comprises a nitrogen-containing functional group;
preferably wherein the nitrogen-containing functional group comprises at least one of an amino group, an amine group, an ammonium group, or a nitrogen-containing heterocyclic group.

7. The carbon abrasive of any of claims 1-6, wherein the positively charged polymer comprises polyvinylpyrrolidone or a derivative of polyvinylpyrrolidone;
preferably wherein a weight average molecular weight of the polyvinylpyrrolidone or the derivative of polyvinylpyrrolidone is 3,000 grams per mole to 150,000 grams per mole.

8. The carbon abrasive of any of claims 1-7, wherein the positively charged polymer is bonded to the surface of the carbon nanoparticle or adsorbed to the surface of the carbon nanoparticle.

9. The carbon abrasive of any of claims 1-8, wherein the carbon nanoparticle is passivated by the positively charged polymer or oligomer.

10. The carbon abrasive of any of claims 1-9, wherein a weight ratio of the carbon nanoparticle and the positively charged polymer is in a range of 1: 5 to 1: 1000.

11. The carbon abrasive of any of claims 1-10, wherein the carbon abrasive exhibits a positive charge in water.

12. A polishing slurry comprising the carbon abrasive of any of claims 1-11;
preferably further comprising an oxidizing agent, a chelating agent, a surfactant, a dispersing agent, a pH controlling agent, a solvent, or a combination thereof.

13. A method of manufacturing a semiconductor device, the method comprising
forming a first layer comprising a first material on a substrate,
forming a plurality of trenches in the first layer,
forming a second layer comprising a second material on the first layer and inside the trenches, the second material being different from the first material, and
chemical mechanical polishing a surface of the second layer using the polishing slurry of claim 12;
preferably wherein the polishing slurry comprises a polishing selectivity of the second layer relative to the first layer of greater than or equal to 500.

14. The method of claim 13, wherein the second material is a metal or an insulator.

15. The method of claims 13 or 14, wherein the first material is a silicon nitride, and the second material is a silicon oxide.
